# EUROPÄISCHE PATENTSCHRIFT

(11) **EP 1 537 653 B1**
(45) Veröffentlichungstag und Bekanntmachung des Hinweises auf die Patenterteilung: **21.12.2005**
(21) Anmeldenummer: 04766223.4
(22) Anmeldetag: 14.07.2004
(51) Int. Cl.: H03F 3/195

(54) **LINEARE VERSTÄRKERANORDNUNG MIT NICHTLINEAREM VERSTÄRKERELEMENT FÜR EINE MOBILE FUNKEINRICHTUNG**
LINEAR AMPLIFICATION DEVICE WITH A NON-LINEAR AMPLIFICATION ELEMENT FOR A MOBILE RADIO DEVICE
ENSEMBLE AMPLIFICATEUR LINEAIRE COMPRENANT UN ELEMENT AMPLIFICATEUR NON LINEAIRE POUR UN DISPOSITIF RADIOTELEPHONIQUE MOBILE

(30) Priorität: 04.09.2003 DE 10340812
(43) Veröffentlichungstag der Anmeldung: 08.06.2005
(73) Patentinhaber: SIEMENS AKTIENGESELLSCHAFT, 80333 München (DE)
(72) Erfinder: WALBRACHT, Jörg, 15732 Schulzendorf (DE)
(86) Internationale Anmeldenummer: PCT/EP2004/051493
(87) Internationale Veröffentlichungsnummer: WO 2005/025054

(56) Entgegenhaltungen:
- US-A- 5 083 094
- US-A- 5 973 559
- MINNIS B J ET AL: "New broadband balun structures for monolithic microwave integrated circuits" MICROWAVE SYMPOSIUM DIGEST, 1991., IEEE MTT-S INTERNATIONAL BOSTON, MA, USA 10-14 JUNE 1991, NEW YORK, NY, USA,IEEE, US, 10. Juni 1991 (1991-06-10), Seiten 425-428, XP010037667 ISBN: 0-87942-591-1

## Beschreibung

Die Erfindung betrifft ein Verfahren und eine Vorrichtung zum Optimieren des Wirkungsgrades einer Verstärkeranordnung mit einem nicht-linearen Leistungsverstärker in einer mobilen Funkeinrichtung.

Im Zuge der Weiterentwicklung des Mobilfunks vom GSM-Standard hin zu EDGE- bzw. weiter dann zum UMTS-Standard werden neue Anforderungen an die Übertragungseigenschaften von Leistungsverstärkern gestellt. Wurde bisher die Information als reine Phaseninformation (GMSK) übertragen, so wird jetzt zur Informationsübertragung zusätzlich die Amplitude ausgewertet. Daraus resultieren verschärfte Anforderungen an die Übertragungseigenschaften der Leistungsverstärker. Zum einen muss das Verstärkerelement extrem linear sein und zum anderen müssen die Übertragungseigenschaften unabhängig gegenüber Temperaturänderungen und Betriebsspannungsschwankungen sein.
Dies ist jedoch in der Regel bei einem Transistor nicht gegeben. Um dies zu erreichen sind daher Maßnahmen zur Minimierung linearer und nicht-linearer Verzerrungen erforderlich. Dies kann zum Beispiel in Form einer Vorentzerrung im Basisband oder Zwischenfrequenz ausgeführt werden oder in Form eines geschlossenen Kreises, wie zum Beispiel eines Polar-Loops, realisiert werden. In jedem Fall ist bei solchen Anordnungen ein erheblicher Abgleich- und/oder Schaltungsaufwand erforderlich.

Die Aufgabe der vorliegenden Erfindung besteht darin, eine effiziente und kosteneffektive Verstärkeranordnung vorzuschlagen.

Die Aufgabe wird erfindungsgemäß durch die Gegenstände der unabhängigen Patentansprüche gelöst. Weiterbildungen der Erfindung sind in den Unteransprüchen angegeben. Ein Kern der Erfindung besteht darin, dass in einer Verstärkeranordnung mit einem nicht-linearen Leistungsverstärker (LV) und zwei im Gegentakt zueinander arbeitenden nachfolgenden Phasenschiebern (PS) jeweils ein zum Eingangssignal phasenverschobenes Signal erzeugt wird. Dabei wird nach den Phasenschiebern Verlustleistung an einem passiven Bauelement umgesetzt. Das passive Bauelement ist mit den Ausgängen der Phasenschieber verbunden. Ein passives Bauelement kann zum Beispiel ein Lastausgleichswiderstand oder ein Symmetrieübertrager mit anschließender Gleichrichteranordnung sein. Hinter dem Leistungsverstärker wird hierfür das amplitudenmodulierte Signal in zwei gleich große Teilsignale bzw. Teilleistungen aufgeteilt und über zwei im Gegentakt arbeitende Phasenschieber geführt. Eine vorteilhafte Ausführungsform stellt die Verwendung eines Symmetrieübertragers als Bauelement dar. Die dabei im Symmetrieübertrager ausgekoppelte Spannung wird an einen Gleichrichter weitergeleitet und der vom Gleichrichter abgegebene Gleichstrom einer Versorgungseinheit als Ladestrom zugeführt. Ein Vorteil dieser Verstärkeranordnung ist, dass der Wirkungsgrad dieser Anordnung entscheidend verbessert werden kann. Des weiteren sind das Verfahren und die Vorrichtung sehr kosteneffektiv.

Die Erfindung wird anhand eines in den Figuren dargestellten Ausführungsbeispiels näher erläutert. Im Einzelnen zeigen
- Figur 1: einen Leistungsverstärker mit nachfolgender Modulationszuführung und Lastausgleichswiderstand,
- Figur 2: eine Verstärkeranordnung zum Rückführen von elektrischer Energie an eine Versorgungseinheit einer mobilen Funkeinrichtung.

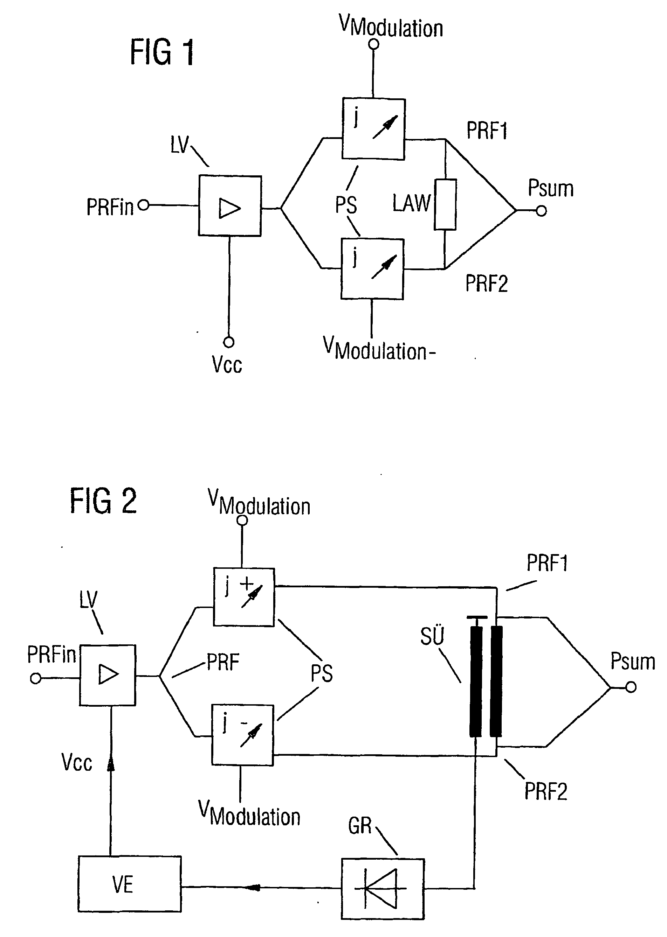

Figur 1 zeigt eine Verstärkeranordnung zur Realisierung eines linearen Verstärkersystems mit nichtlinearen Verstärkerkomponenten. Einem Leistungsverstärker LV im C-Betrieb (praktisch realisierbarer Wirkungsgrad ca. 75%) werden zwei mit einem Modulationssignal steuerbare Phasenschieber PS nachgeschaltet. Prinzipiell funktioniert die Schaltung mit jeder Art von Verstärkertyp (A, B oder C), jedoch wird der Wirkungsgrad bei einem anders als im C-Betrieb betriebenen Verstärker LV verschlechtert.
Hinter dem Leistungsverstärker LV wird das erzeugte Signal bzw. die Leistung PRF in zwei gleich große Teilsignale bzw. Teilleistungen PRF 1 und PRF 2 aufgeteilt und diese Teilleistungen über die im Gegentakt arbeitenden Phasenschieber PS geführt. Entsprechend von Amplitudeninformationen wird die Leistung (RF) als Verlustleistung im Lastausgleichwiderstand LAW umgesetzt. Amplitudeninformationen sind dabei Hüllkurveninformationen. Hier besteht auch der wesentliche Nachteil dieser Schaltungsanordnung. Entsprechend dem Crest Faktor (Verhältnis von Spitzenleistung zu Mittelwertleistung) muss der C Leistungsverstärker LV für die zu übertragende Spitzenleistung ausgelegt sein. Dies führt jedoch in einer solchen Schaltungsanordnung dazu, dass ein Großteil der erzeugten RF - Leistung PRF im Lastausgleichwiderstand LAW umgesetzt wird.

Figur 2 zeigt eine Verstärkeranordnung zum Rückführen von elektrischer Energie an eine Versorgungseinheit einer mobilen Funkeinrichtung. Erkennbar ist wiederum der Leistungsverstärker LV aus Figur 1 im C-Betrieb mit nachfolgender Leistungsaufteilung PRF 1 und PRF 2 und den steuerbaren Phasenschiebern PS. Prinzipiell funktioniert die Schaltung mit jeder Art von Verstärkertyp (A, B oder C), jedoch wird der Wirkungsgrad bei einem anders als im C-Betrieb betriebenen Leistungsverstärker LV verschlechtert. Entfallen ist der Lastausgleichwiderstand LAW, der durch einen Symmetrieübertrager SÜ (Ballun) ersetzt wird. Des weiteren ist eine Gleichrichteranordnung GR mit Verbindung zur Gleichspannungsversorgungseinheit VE hinzugekommen. Aufgabe dieser neu hinzugekommenen Schaltungsanordnung ist es, die bisher im Lastausgleichwiderstand LAW umgesetzte Verlustleistung (HF) der Versorgungseinheit (Batterie, Netzteil, etc.) einer mobilen Funkeinrichtung, einer Mobilstation für ein zellulares Mobilfunknetz als Gleichstrom wieder zuzuführen. Nach dem Leistungsverstärker LV werden die Teilleistungen PRF 1 und PRF 2 über die Phasenschieber PS geführt. Mit diesen Phasenschiebern PS wird die elektrische Länge bzw. die Durchlaufzeit der Teilleistungen PRF 1 und PRF 2 beeinflusst. So wird z. B. die Teilleistung PRF 1 im Pfad 1 durch den Phasenschieber PS erhöht, und die Durchlaufzeit im Pfad 2 durch den anderen Phasenschieber PS verringert (Gegentakt). Vorstellbar ist dies durch zwei Vektoren, die vor dem Phasenschieber PS gleiche Phasenlage haben und nach dem Phasenschieber PS unterschiedlich sind. Dadurch ergibt sich bei der Addition beider Teilvektoren vor und nach den Phasenschiebern PS vom Betrag her ein unterschiedlich langer Summenvektor. Gesteuert werden die Phasenschieber PS durch ein Modulationssignal, das z. B. ein Audiosignal, ein Videosignal oder eine ähnliche Information sein kann. Das Modulationssignal kann aus dem Eingangssignal (Nutzsignal) ausgekoppelt werden. Es kann aber auch ein beliebiges Signal sein. Ist die Steuerspannung der Phasenschieber PS ungleich Null entsteht an dem Symmetrieübertrager SÜ ein Spannungsabfall. Die Steuerspannung entspricht dem Modulationssignal und ist somit dann Null, wenn die Modulationsspannung Null ist. Über den Symmetrieübertrager SÜ wird diese Spannung auf die Sekundärseite des Übertragers SÜ übertragen und wird dort auf ein Potential referenziert. In diesem Beispiel ist dies mit einem Masse-Symbol dargestellt. Ein Bezug auf z. B. ein Batteriepotential ist aber auch jederzeit denkbar. Anschließend wird die Spannung mit einem Mehrwegegleichrichter gleichgerichtet und eine Siebung durchgeführt. Mit einem Mehrwegegleichrichter wird der größtmögliche Wirkungsgrad erreicht. Ein anderer Gleichrichter ist ebenso vorstellbar. Der sich einstellende Gleichstrom kann dann der Versorgungseinheit VE zugeführt werden. Um die Funktionalität der Gesamtschaltung zu gewährleisten ist es wichtig, dass die Eingangsimpedanz des Gleichrichters GR nahezu aussteuerungsunabhängig ist. Wenn die Eingangsimpedanz des Gleichrichters nicht konstant ist, werden nicht-lineare Verzerrungen erzeugt, welche die Funktion der Gesamtschaltung beeinflussen. Um alle Signalanteile verzerrungsfrei zu übertragen, muss der C-Verstärker LV so ausgelegt sein, dass die maximal auftretenden Spitzenleistungen übertragen werden können. Dies bedeutet, dass der Verstärker LV mit einer konstanten Leistung läuft, die um den Crest Faktor über der am Ausgang gewünschten Mittelwertsleistung liegt. Bei heute üblichen Übertragungsverfahren liegt der Crest Faktor im Bereich 3dB bis 10dB. Wird der C-Verstärker LV für einen Crest Faktor von 10dB dimensioniert, so bedeutet dies bei der Anordnung mit Lastausgleichswiderstand LAW (Figur 1), dass ca. 90 % der erzeugten Leistung im Lastausgleichwiderstand LAW als Verlustleistung umgesetzt werden würde. Mit der erweiterten Schaltung besteht nun die Möglichkeit diesen Verlustleistungsanteil (HF) aufzufangen und einer Versorgungseinheit VE als Ladestrom zuzuführen. Es wird also eine HF (Verlustleistung) - DC (Gleichstrom) Wandlung durchgeführt.

## Patentansprüche

1. Verfahren zum Optimieren des Wirkungsgrades einer Verstärkeranordnung mit einem nicht-linearen Leistungsverstärker (LV) in einer mobilen Funkeinrichtung,
**dadurch gekennzeichnet,**
**dass** in der Verstärkeranordnung mit einem nicht-linearen Leistungsverstärker (LV) und zwei im Gegentakt zueinander arbeitenden nachfolgenden Phasenschiebern (PS) jeweils ein zum Eingangssignal phasenverschobenes Signal erzeugt wird und dass die Ausgänge der Phasenschieber (PS) durch ein passives Bauelement (SÜ, LAW) verbunden sind.

2. Verfahren nach Anspruch 1,
**dadurch gekennzeichnet,**
**dass** als passives Bauelement ein Symmetrieübertrager (SÜ) in der Verstärkeranordnung verwendet wird.

3. Verfahren nach einem der vorhergehenden Ansprüche,
**dadurch gekennzeichnet,**
**dass** nach den Phasenschiebern (PS) eine Leistung an einem passiven Bauelement (SÜ, LAW) entnommen wird.

4. Verfahren nach einem der vorhergehenden Ansprüche,
**dadurch gekennzeichnet,**
**dass** ein amplitudenmoduliertes Signal von der Verstärkeranordnung mit einem Leistungsverstärker (LV) und zwei im Gegentakt zueinander arbeitenden nachfolgenden Phasenschiebern (PS) mittels zugeführter Amplitudeninformationen erzeugt wird.

5. Verfahren nach einem der vorhergehenden Ansprüche,
**dadurch gekennzeichnet,**
**dass** als passives Bauelement ein Lastausgleichswiderstand (LAW) in der Verstärkeranordnung verwendet wird.

6. Verfahren nach einem der vorhergehenden Ansprüche,
**dadurch gekennzeichnet,**
**dass** in einem Symmetrieübertrager (SÜ) eine Spannung ausgekoppelt wird, die in einem Gleichrichter (GR) gleichgerichtet wird, wobei der vom Gleichrichter (GR) abgegebene Gleichstrom einer Versorgungseinheit (VE) als Ladestrom zugeführt wird.

7. Verfahren nach einem der vorhergehenden Ansprüche,
**dadurch gekennzeichnet,**
**dass** in einem den Phasenschiebern (PS) nachgeordneten Lastausgleichswiderstand (LAW) Verlustleistung entsteht.

8. Verfahren nach einem der vorhergehenden Ansprüche,
**dadurch gekennzeichnet,**
**dass** die im Gegentakt arbeitenden Phasenschieber (PS) über ein Modulationssignal gesteuert werden.

9. Verfahren nach einem der vorhergehenden Ansprüche,
**dadurch gekennzeichnet,**
**dass** die Verlustleistung in einem Symmetrieübertrager (SÜ) auf ein Spannungspotential referenziert wird.

10. Verfahren nach einem der vorhergehenden Ansprüche,
**dadurch gekennzeichnet,**
**dass** das vom Leistungsverstärker (LV) erzeugte Signal in zwei gleich große Teilsignale (PRF 1, PRF 2) aufgeteilt und den beiden Phasenschiebern (PS) zugeführt wird.

11. Verfahren nach einem der vorhergehenden Ansprüche,
**dadurch gekennzeichnet,**
**dass** die Eingangsimpedanz des Gleichrichters (GR) aussteuerungsunabhängig ist.

12. Verfahren nach einem der vorhergehenden Ansprüche,
**dadurch gekennzeichnet,**
**dass** als Gleichrichter (GR) ein Ein- und/oder MehrwegeGleichrichter verwendet wird.

13. Verfahren nach einem der vorhergehenden Ansprüche,
**dadurch gekennzeichnet,**
**dass** der Leistungsverstärker (LV) zur verzerrungsfreien Übertragung der Signalanteile so ausgebildet ist, dass die maximal auftretenden Spitzenleistungen mit einer Abweichung bis 6 dB übertragen werden können.

14. Verfahren nach einem der vorhergehenden Ansprüche,
**dadurch gekennzeichnet,**
**dass** die übertragene Leistung des Leistungsverstärkers (LV) bis zu 6 dB um den Crest Faktor über der am Ausgang gewünschten Mittelwertleistung liegt.

15. Verfahren nach einem der vorhergehenden Ansprüche,
**dadurch gekennzeichnet,**
**dass** die Versorgungseinheit (VE) eine Batterie, ein Netzteil und/oder Ähnliches ist.

16. Verstärkeranordnung für eine mobile Funkeinrichtung,
- mit einem nicht-linearen Leistungsverstärker (LV) und zwei im Gegentakt zueinander arbeitenden, jeweils an den Leistungsverstärker (LV) angeschlossenen Phasenschiebern (PS) zum Erzeugen jeweils eines zum Eingangssignal phasenverschobenen Signals,
- mit einem mit den Ausgängen der Phasenschieber (PS) verbundenen passiven Bauelement (SÜ, LAW).

17. Vorrichtung nach Anspruch 16,
**dadurch gekennzeichnet,**
**dass** als Bauelement ein Symmetrieübertrager (SÜ) zum Referenzieren der am Symmetrieübertrager (SÜ) abfallenden Leistung auf ein Spannungspotential vorgesehen ist.

18. Vorrichtung nach einem der vorhergehenden Ansprüche,
**dadurch gekennzeichnet,**
**dass** als Bauelement ein Lastausgleichswiderstand (LAW) vorgesehen ist.

19. Vorrichtung nach einem der vorhergehenden Ansprüche,
**dadurch gekennzeichnet,**
**dass** ein Symmetrieübertrager (SÜ) zum Auskoppeln einer Spannung vorgesehen ist und
**dass** ein Gleichrichter (GR) zum Gleichrichten der Spannung und zur Zuführung des abgegebenen Gleichstroms an eine Versorgungseinheit (VE) als Ladestrom vorgesehen ist.

20. Vorrichtung nach einem der vorhergehenden Ansprüche,
**dadurch gekennzeichnet,**
**dass** nach den Phasenschiebern (PS) ein Lastausgleichswiderstand (LAW) zum Umsetzen der Leistung vorgesehen ist.

## Claims

1. Method for optimizing the efficiency of an amplifier arrangement with a non-linear power amplifier (LV) in a mobile radio device.
**characterized in that**,
the amplifier arrangement with a non-linear power amplifier (LV) and two subsequent push-pull phase modifiers (PS) generates a signal offset in phase from the input signal and that the outputs of the phase modifiers (PS) are connected by a passive component (SU, LAW).

2. Method according to Claim 1,
**characterized in that**,
a symmetrical transformer (SÜ) of the amplifier arrangement is used as the passive component.

3. Method according to one of the previous claims
**characterized in that**,
after the phase modifiers (PS) a power is obtained at a passive component (SÜ, LAW).

4. Method according to one of the previous claims
**characterized in that**,
an amplitude-modulated signal is generated by the amplifier arrangement with a power amplifier (LV) and two push-pull successive phase modifiers (PS) by means of fed amplitude information.

5. Method according to one of the previous claims
**characterized in that**,
a load balancing resistor (LAW) is used in the amplifier arrangement as the passive component.

6. Method according to one of the previous claims
**characterized in that**,
in a symmetrical transformer (SÜ) a voltage is decoupled which is rectified in a rectifier (GR), with the direct current output by the rectifier (GR) being fed to a supply unit (VE) as charge current.

7. Method according to one of the previous claims
**characterized in that**,
Power is dissipated in load balancing resistor (LAW) which follows the phase modifiers (PS).

8. Method according to one of the previous claims
**characterized in that**,
the push-pull phase modifiers (PS) are controlled using a modulation signal.

9. Method according to one of the previous claims
**characterized in that**,
the power dissipation is referenced in a symmetrical amplifier (SÜ) to a voltage potential.

10. Method according to one of the previous claims
**characterized in that**,
the signal generated by the power amplifier (LV) is divided into two part signals of equal size (PRF 1, PRF 2) and fed to the two phase modifiers (PS).

11. Method according to one of the previous claims
**characterized in that**,
the input impedance of the rectifier (GR) is amplitude-independent.

12. Method according to one of the previous claims
**characterized in that**,
a single-path or multipath rectifier is used as the rectifier (GR).

13. Method according to one of the previous claims
**characterized in that**,
the power amplifier (LV) is embodied for distortion-free transmission of the signal components such that the maximum peak power arising can be transmitted with a deviation of up to 6 dB.

14. Method according to one of the previous claims
**characterized in that**,
the transmitted power of the power amplifier (LV) lies up to 6 dB around the crest factor above the average power required at the output.

15. Method according to one of the previous claims
**characterized in that**,
the supply unit (VE) is a battery, an ac adapter and/or similar.

16. Amplifier arrangement for a mobile radio device,
- with a non-linear power amplifier (LV) and two push-pull phase modifiers (PS) each connected to the power amplifier (LV) to create a signal offset in phase to the input signal in each case,
- with a passive component (SÜ, LAW) connected to the outputs of the phase modifiers (PS).

17. Device in accordance with Claim 16,
**characterized in that**,
a symmetrical transformer (SÜ) for referencing the power dropping at the symmetrical transformer (SÜ) to a voltage potential is provided as the component.

18. Device in accordance with one of the previous claims,
**characterized in that**,
a load balancing resistor (LAW) is provided as the component.

19. Device in accordance with one of the previous claims,
**characterized in that**,
a symmetrical transformer (SÜ) is provided for decoupling a voltage and
a rectifier (GR) is provided for rectifying the voltage and for feeding the direct current output to a supply unit (VE) as charge current.

20. Device in accordance with one of the previous claims,
**characterized in that**,
a load balancing resistor (LAW) is provided after the phase modifiers (PS) for converting the power.

## Revendications

1. Procédé d'optimisation du rendement d'un dispositif amplificateur comprenant un amplificateur de puissance non linéaire (LV) dans un dispositif radiotéléphonique mobile,
**caractérisé en ce**
**qu'**un signal déphasé par rapport au signal d'entrée est respectivement généré dans le dispositif amplificateur comprenant un amplificateur de puissance (LV) non linéaire et deux déphaseurs (PS) installés en aval, fonctionnant symétriquement l'un par rapport à l'autre, et en ce que les sorties des déphaseurs (PS) sont raccordées au moyen d'un composant passif (SÜ, LAW).

2. Procédé selon la revendication 1,
**caractérisé en ce**
**qu'**un transformateur symétrique (SÜ) est utilisé comme composant passif dans le dispositif amplificateur.

3. Procédé selon l'une quelconque des revendications précédentes,
**caractérisé en ce**
**qu'**une puissance est prise sur un composant passif (SÜ, LAW) en aval des déphaseurs (PS).

4. Procédé selon l'une quelconque des revendications précédentes,
**caractérisé en ce**
**qu'**un signal modulé en amplitude est généré par le dispositif amplificateur comprenant un amplificateur de puissance (LV) et deux déphaseurs (PS) installés en aval, fonctionnant symétriquement l'un par rapport à l'autre, au moyen d'informations d'amplitude fournies.

5. Procédé selon l'une quelconque des revendications précédentes,
**caractérisé en ce**
**qu'**une résistance de compensation de charge (LAW) est utilisée comme composant passif dans le dispositif amplificateur.

6. Procédé selon l'une quelconque des revendications précédentes,
**caractérisé en ce**
**qu'**une tension, qui est redressée dans un redresseur (GR), est découplée dans un transformateur symétrique (SÜ), le courant continu déchargé par le redresseur (GR) étant amené à une unité d'alimentation (VE) en tant que courant de charge.

7. Procédé selon l'une quelconque des revendications précédentes,
**caractérisé en ce**
**qu'**il se produit de la puissance dissipée dans une résistance de compensation de charge (LAW) placée en aval des déphaseurs (PS).

8. Procédé selon l'une quelconque des revendications précédentes,
**caractérisé en ce**
**que** les déphaseurs (PS) fonctionnant symétriquement sont commandés par l'intermédiaire d'un signal de modulation.

9. Procédé selon l'une quelconque des revendications précédentes,
**caractérisé en ce**
**que** la puissance dissipée est référencée sur un potentiel de tension dans un transformateur symétrique (SÜ).

10. Procédé selon l'une quelconque des revendications précédentes,
**caractérisé en ce**
**que** le signal généré par l'amplificateur de puissance (LV) est divisé en deux signaux partiels égaux (PRF 1, PRF 2) et en ce qu'il est amené aux deux déphaseurs (PS).

11. Procédé selon l'une quelconque des revendications précédentes,
**caractérisé en ce**
**que** l'impédance d'entrée du redresseur (GR) est indépendante de la modulation.

12. Procédé selon l'une quelconque des revendications précédentes,
**caractérisé en ce**
**qu'**un redresseur demi-onde et/ou un redresseur à plusieurs demi-ondes est utilisé comme redresseur (GR).

13. Procédé selon l'une quelconque des revendications précédentes,
**caractérisé en ce**
**que** l'amplificateur de puissance (LV) est exécuté pour la transmission sans distorsion des fractions de signal, de telle manière que les puissances de crête maximales se produisant peuvent être transmises avec un écart allant jusqu'à 6 dB.

14. Procédé selon l'une quelconque des revendications précédentes,
**caractérisé en ce**
**que** la puissance transmise de l'amplificateur de puissance (LV) se situe jusqu'à 6 dB au-delà de la puissance moyenne souhaitée sur la sortie, par rapport au facteur de crête.

15. Procédé selon l'une quelconque des revendications précédentes,
**caractérisé en ce**
**que** l'unité d'alimentation (VE) est une batterie, un bloc d'alimentation et/ou similaire.

16. Dispositif amplificateur pour un dispositif radiotéléphonique mobile,
- comprenant un amplificateur de puissance (LV) non linéaire et deux déphaseurs (PS) respectivement raccordés à l'amplificateur de puissance (LV), fonctionnant symétriquement l'un par rapport à l'autre, pour générer respectivement un signal déphasé par rapport au signal d'entrée,
- comprenant un composant passif (SÜ, LAW) raccordé aux sorties des déphaseurs (PS).

17. Dispositif selon la revendication 16,
**caractérisé en ce**
**qu'**un transformateur symétrique (SÜ) est prévu comme composant pour référencer la puissance baissant sur le transformateur symétrique (SÜ) sur un potentiel de tension.

18. Dispositif selon l'une quelconque des revendications précédentes,
**caractérisé en ce**
**qu'**une résistance de compensation de charge (LAW) est prévue comme composant.

19. Dispositif selon l'une quelconque des revendications précédentes,
**caractérisé en ce**
**qu'**un transformateur symétrique (SÜ) est prévu pour découpler une tension et
en ce qu'un redresseur (GR) est prévu pour redresser la tension et pour amener le courant continu déchargé à une unité d'alimentation (VE) en tant que courant de charge.

20. Dispositif selon l'une quelconque des revendications précédentes,
**caractérisé en ce**
**qu'**une résistance de compensation de charge (LAW) est prévue en aval des déphaseurs (PS) pour transformer la puissance.
